# FASCICULE DE BREVET EUROPEEN

(11) **EP 0 376 062 B1**
(45) Date de publication et mention de la délivrance du brevet: **15.02.1995**
(21) Numéro de dépôt: 89123010.4
(22) Date de dépôt: 13.12.1989
(51) Int. Cl.: G06K 19/06

(54) **Module électronique pour un objet portatif de petite dimension, tel qu'une carte ou une clef, à circuit intégré, et procédé de fabrication de tels modules**
Elektronisches Modul mit einer integrierten Schaltung für ein kleines tragbares Objekt, z.B. eine Karte oder ein Schlüssel und Herstellungsverfahren für solche Module
Electronic module with an integrated circuit for a portable object of small dimensions, such as a card or a key, and process for manufacturing such a module

(30) Priorité: 27.12.1988 FR 8817210
(43) Date de publication de la demande: 04.07.1990
(73) Titulaire: Eta SA Fabriques d'Ebauches, 2540 Granges (CH)
(72) Inventeur: Stampfli, Jean-Marcel, CH-2525 Le Landeron (CH)
(74) Mandataire: Barbeaux, Bernard

(56) Documents cités:
- WO-A-84/01688
- WO-A-88/00785
- FR-A- 2 044 691
- GB-A- 2 149 209
- Conference Record of the 1987 IEEE Industry Applications Society Annual MeetingPart II 18-23 October 1987, Atlanta (US): R. M. AMES: "Radio Frequency in theAutomatic ID Marketplace" pages 1231-1243

## Description

La présente invention a trait à un module électronique destiné à la fabrication d'objets portatifs de petite dimension comme des cartes à circuits intégrés, par exemple des cartes de crédit, des cartes bancaires, des cartes de paiement d'appels téléphoniques dans des cabines publiques, des cartes d'accès à des lieux payants, privés ou protégés, ou des clefs également à circuits intégrés qui peuvent avoir la même utilité.

Telles qu'elles sont réalisées actuellement les cartes à circuits intégrés comportent le plus souvent un ensemble de plages de contact électrique qui sont accessibles pour les pièces de connexion d'appareils dans lesquels ces cartes doivent être introduites.

Pour certaines applications comme par exemple le contrôle d'accès à des locaux privés ou protégés le circuit intrégré d'une carte peut se limiter à une mémoire qui est reliée directement aux plages de contact par des conducteurs électriques et qui contient une ou plusieurs informations qu'un appareil prévu pour recevoir la carte est seulement capable de lire.

Pour d'autres applications, comme par exemple celles où la carte permet à son possesseur d'effectuer des paiements ou des transactions, le circuit comprend en plus un microprocesseur qui est interposé entre les plages de contact et la mémoire et qui peut être intégré sur la même puce que cette dernière ou sur une puce séparée. A ce moment-là les appareils avec lesquels la carte peut être utilisée peuvent non seulement lire les informations contenues dans sa mémoire mais aussi y en inscrire d'autres.

Par ailleurs, dans certains cas, les différents éléments qui forment le circuit électronique de la carte sont, à l'exception des plages de contact, noyés dans un corps isolant homogène ou composite pour former un module qui est ensuite placé dans une ouverture correspondante d'un corps de carte. Dans d'autres, au contraire, ces éléments sont incorporés directement dans le corps de carte.

Indépendamment des questions liées au circuit intégré lui-même, comme par exemple celles de savoir quelles informations la mémoire doit contenir, quelles fonctions doit remplir le microprocesseur lorsqu'il existe, de quelle façon doivent être conçus cette mémoire et éventuellement ce microprocesseur, la fabrication de ces cartes à circuits intégrés dont on vient de parler pose un certain nombre de problèmes, notamment à cause des exigences assez nombreuses auxquelles elles doivent répondre.

Tout d'abord ces cartes doivent avoir généralement le même format qu'une carte à piste magnétique standardisée, c'est-à-dire une longueur de 85 mm, une largeur de 54 mm et une épaisseur de 0,76 mm (normes ISO), ou tout au moins des dimensions voisines de celles-ci pour rester peu encombrantes et facilement maniables.

Si l'on se rend compte que, premièrement, une épaisseur de 760 microns ne correspond grossièrement qu'à deux fois celle d'une puce de circuit intégré sans protection, que, deuxièmement, la portion de la surface d'une carte qui peut être allouée au circuit électronique est souvent très limitée, étant donné que la majeure partie de celle-ci doit être réservée à des inscriptions telles que la dénomination du prestataire qui délivre la carte, l'identité du porteur, une signature, des informations d'utilisation et éventuellement une photo et que, troisièmement, les plages conductrices doivent être suffisamment grandes pour que le contact avec les pièces de connexion d'un appareil soit assuré et bon, on en déduit très vite que l'on ne peut utiliser des circuits standardisés déjà enrobés ou emboîtés comme ceux que l'on trouve actuellement sur le marché et qui sont trop volumineux.

On est donc obligé, pour fabriquer les cartes ou les modules électroniques qui leur sont destinés, de partir de puces de circuits intégrés nues, de réaliser soi même le réseau d'interconnexion qui permet de relier électriquement ces puces avec l'extérieur et entre elles si il y en a plusieurs dans une même carte et d'assurer la protection de l'ensemble qui est naturellement très fragile surtout au niveau des jonctions entre les pièces conductrices (bornes de connexion des puces, fils, etc).

Cette protection doit être d'autant plus efficace que les cartes seront amenées à subir très souvent des déformations qui pourront être importantes du fait que l'on demande généralement à ces cartes, comme aux cartes classiques, de répondre à des normes ou à des exigences de flexibilité relativement sévères et elle ne peut pas être assurée en donnant au modules électroniques ou aux zones des cartes dans lesquelles les circuits sont placés, la plus grande rigidité possible car les conditions de flexibilité en question ne seraient plus remplies.

De plus, il faut éviter que des agents extérieurs, comme la lumière ou l'humidité puissent venir détériorer le circuit ou en perturber le fonctionnement.

Pour des clefs electroniques qui présentent elles aussi des plages de contact mais qui n'ont pas à être minces comme des cartes et qui ont au contraire besoin d'être rigides, ces problèmes de protection de la puce ou des puces et des liaisons électriques ne se posent pratiquement pas car celles-ci sont alors noyées dans des blocs relativement massifs de matière plastique dure qui donnent leurs formes à ces clefs.

Par contre, il y a au moins deux autres problèmes dont on n'a pas encore parlé et qui se posent aussi bien pour les clefs que pour les cartes.

Le premier de ces problèmes c'est que, dans les deux cas, les plages de contact doivent être conçues pour pouvoir résister le mieux possible à l'usure à laquelle elles sont soumises par les pièces de connexion des appareils destinés à les recevoir et fréquemment aussi pour être capables de remplir correctement leur rôle même dans un milieu hostile comme par exemple une atmosphère humide ou polluante. C'est la raison pour laquelle ces plages sont souvent formées de plusieurs couches superposées de métaux différents, par exemple de cuivre, de nickel et d'or, ce qui a évidemment pour inconvénient d'augmenter le prix de revient de la carte ou de la clef.

Le second problème c'est que les plages de contact en question peuvent être soumises à des décharges électrostatiques d'intensité supérieure à celle pour laquelle les systèmes qui sont prévus dans les circuits intégrés pour les protéger contre de telles décharges sont encore efficaces. Lorsque cela arrive ces circuits sont détruits et les cartes ou les clefs dont ils font partie sont rendues inutilisables.

Cela dit, il existe aussi actuellement des systèmes dans lesquels les échanges d'informations entre une carte et un appareil de lecture et d'écriture ne se font pas par contact électrique comme dans ceux dont il vient d'être question mais par un couplage inductif entre deux bobines que comportent respectivement la carte et l'appareil dans lequel elle peut être introduite.

Dans ces systèmes le circuit intégré de la carte est logé dans une ouverture prévue dans le corps de celle-ci et la bobine est constituée par une bande métallique qui a été formée sur ce corps en utilisant la technique classique des circuits imprimés.

Donc, dans ce cas les problèmes liées aux contacts n'existent plus. Par contre, ceux qui concernent la protection de la ou des puces et des liaisons électriques entre les différents éléments du circuit électronique de la carte subsistent.

D'autre part, les cartes de ce genre présentent au moins un inconvénient: c'est qu'à cause de la bobine leur prix de revient est relativement élevé, plus que celui de la plupart des cartes à contact, et que ce prix augmente en proportion de la surface que cette bobine occupe sur le corps de carte.

Or, il y a évidemment toujours intérêt à ce que des cartes à circuits intégrés reviennent le moins cher possible, surtout lorsqu'il s'agit de cartes auxquelles est attribuée initialement une certaine valeur que l'on paie en les achetant et qui, lorsque cette valeur est épuisée, doivent tout simplement être jetées.

L'un des buts de l'invention est précisément de permettre de réaliser des cartes sans contact, comme celles dont on vient de parler, à bas prix et d'apporter une solution satisfaisante au problème de la protection des parties fragiles de leur circuit électronique en fournissant un module électronique complet conçu pour pouvoir être placé et fixé dans un corps de carte de la même façon qu'un module de carte à contacts.

Un autre but de l'invention est que ce module puisse aussi servir à fabriquer non seulement des clefs qui pourraient remplacer ces cartes dans certaines au moins de leurs applications mais aussi par exemple des étiquettes et d'autres cartes comme celles que l'on utilise actuellement dans des systèmes d'identification à plus ou moins grande distance de personnes ou d'objets et qui comportent une antenne inductive reliée à un circuit intégré pour émettre et recevoir des ondes électromagnétiques de fréquences radio.

Les objets portatifs qui font partie de ces systèmes d'identification peuvent en effet poser les mêmes problèmes que les cartes sans contacts dont on a parlé précédemment. Ce serait le cas par exemple si l'on plaçait le répondeur qui est décrit dans la demande de brevet WO-A-8800785 dans une carte. Ce répondeur comprend trois puces de circuits intégrés qui sont montées sur une plaquette de circuit imprimé et entourées par une bobine formée par une piste de ce circuit et reliée à l'une des puces. Donc, si la carte était soumise à des déformations les liaisons électriques entre les puces et entre une de ces puces et la bobine risqueraient de se rompre et cette carte reviendrait cher à cause de la façon dont la bobine est réalisée.

Les buts énoncés précédemment sont atteints grâce au fait que le module selon l'invention qui comprend un substrat en matière électriquement isolante, une puce de circuit intégré munie d'au moins deux bornes de connexion, qui est fixée au moins indirectement sur le substrat, une bobine munie de deux bornes et également fixée sur le substrat, pour permettre un couplage inductif entre le module et un appareil avec lequel l'objet auquel il est destiné sera amené à coopérer, et des liaisons électriques respectives entre les bornes de connexion de la puce et les bornes de la bobine et dans lequel la bobine a une forme annulaire et entoure un espace dans lequel sont logées la puce et les liaisons électriques, est caractérisé par le fait que cette bobine a une hauteur supérieure à l'épaisseur de la puce et que ledit espace est rempli d'une matière adhésive, électriquement isolante et durcie.

Par ailleurs, l'invention a également pour objet un procédé de fabrication en série de modules tels que définis ci-dessus qui est principalement caractérisé par le fait que :
- on se munit tout d'abord d'un ruban en matière électriquement isolante;
- on fixe au moins indirectement les puces sur le ruban dans sa partie centrale et de façon à ce qu'elles soient régulièrement réparties dans le sens de sa longueur;
- on fixe les bobines sur le ruban, autour des puces;
- on réalise des liaisons électriques entre les bornes de connexion des puces et les bornes des bobines;
- on remplit les espaces entourés par les bobines d'une matière adhésive isolante et durcissable; et, après que cette matière ait durci,
- on découpe le ruban autour de chaque bobine pour obtenir les modules.

D'autres caractéristiques et avantages de l'invention apparaîtront à la lecture de la description qui suit de deux modes de mise en oeuvre de ce procédé, choisis comme exemples, et de deux formes possibles de réalisation des modules selon l'invention qui en résultent. Cette description se réfère au dessin annexé sur lequel :
- la figure 1 montre partiellement, en plan, un ruban isolant, perforé et recouvert d'une couche de matière adhésive que l'on utilise pour fabriquer des modules conformément au premier de ces modes de mise en oeuvre du procédé selon l'invention;
- les figures 2, 3 et 4 montrent en perspective, respectivement, une puce de circuit intégré, une bobine, représentée coupée en deux, et un plot métallique comme ceux que l'on utilise également conformément à ce premier mode de mise en oeuvre;
- les figures 5 et 6 montrent le ruban de la figure 1 sur lequel sont montées différentes parties des modules, à deux stades d'avancement de leur fabrication;
- la figure 7 est une vue en coupe de l'un de ces modules, lorsqu'il est terminé;
- la figure 8 montre comment un module comme celui de la figure 7 peut être incorporé dans une carte;
- la figure 9 est une vue analogue à celles des figures 5 et 6 qui illustre la fabrication de modules selon le deuxième mode de mise en oeuvre du procédé selon l'invention qui a été choisi comme exemple, et qui correspond à un certain stade de cette fabrication;
- la figure 10 est une vue en coupe partielle et à plus grande échelle, selon le plan X-X de la figure 9;
- la figure 11 est une vue semblable à celle de la figure 9, qui correspond à un stade plus avancé de la fabrication des mêmes modules;
- la figure 12 est une vue en coupe partielle et à plus grande échelle, selon le plan XII-XII de la figure 11;
- la figure 13 est une vue analogue à celle des figures 9 et 11, qui correspond à un troisième stade d'avancement toujours de la fabrication des mêmes modules; et
- la figure 14 est une vue en coupe de l'un de ces modules, terminé.

Les deux modes de mise en oeuvre du procédé selon l'invention que l'on a choisis comme exemples vont être décrits dans le cas où ils sont employés pour produire des modules électroniques qui ne comprennent qu'une seule puce de circuit intégré mais, comme on le verra, ils peuvent également convenir pour des modules à deux puces et même plus.

De plus, ils sont conçus pour que ces modules puissent être fabriqués de la manière la plus automatisée possible, en utilisant des techniques bien connues dans le domaine de l'électronique, et par conséquent pour permettre d'abaisser au maximum leur prix de revient.

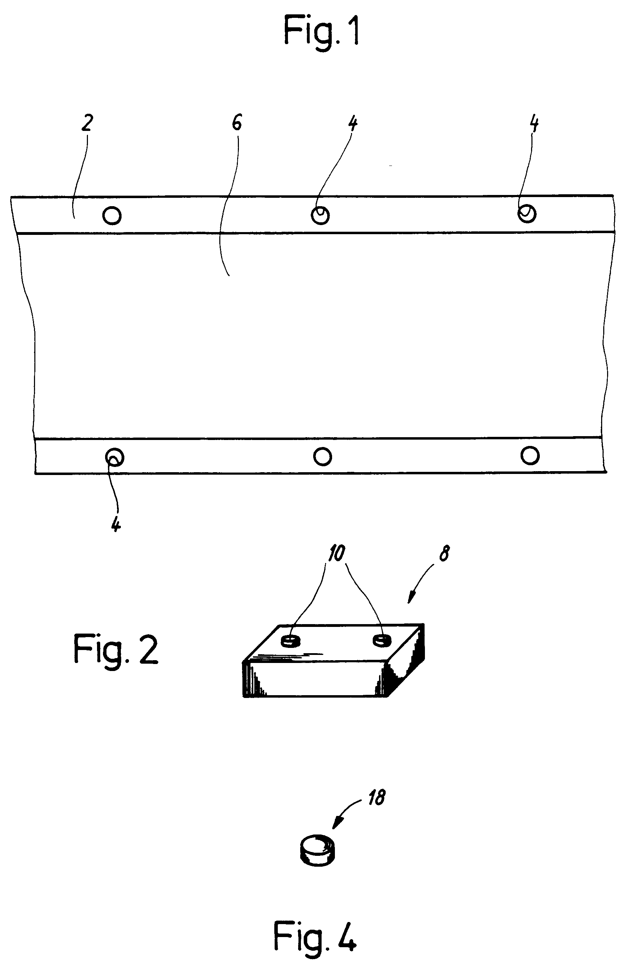

Pour réaliser des modules conformément au premier de ces modes de mise en oeuvre on commence par se munir, entre autres, d'un ruban de grande longueur 2, qui est représenté partiellement sur la figure 1, et qui est formé d'une matière électriquement isolante, comme le polyester connu sous la marque "Mylar" ou le polyimide commercialisé sous la marque "Kapton".

Ce ruban 2 est destiné non seulement à former les substrats des modules mais également à supporter leurs différents éléments, à déplacer ceux-ci sur une machine et à les transférer d'une machine à une autre pendant leur assemblage.

Pour cette raison, lorsque l'on est en sa possession, on le soumet tout d'abord à une opération d'étampage pour qu'il présente le long de chacun de ses bords une série de perforations équidistantes 4 qui permettront de le positionner et de le faire défiler devant les différents outils qui seront utilisés.

Ensuite, lorsque cette opération d'étampage est terminée, on enduit la partie centrale de l'une de ses faces, qui se trouve entre les deux rangées de perforations 4, d'une mince couche 6 de matière adhésive isolante et thermodurcissable à l'état B, c'est-à-dire dans un état semi-polymérisé où elle est encore suffisamment molle et collante pour pouvoir retenir des objets que l'on applique sur elle avec une certaine force. Cette matière peut être par exemple une résine époxyde.

A noter que les sociétés qui commercialisent des rubans comme le ruban 2 vendent aussi le plus souvent des rubans standardisés de différentes épaisseurs qui présentent les mêmes largeurs et les mêmes perforations que les films cinématographiques et qui sont déjà munis d'une couche de matière adhésive comme la couche 6. Donc, si l'un de ces rubans déjà tout préparés convenait pour les modules que l'on veut fabriquer et les machines que l'on a l'intention d'utiliser, on pourrait éventuellement se le procurer et éviter ainsi d'avoir à effectuer soi-même les opérations d'étampage et d'encollage dont on vient de parler.

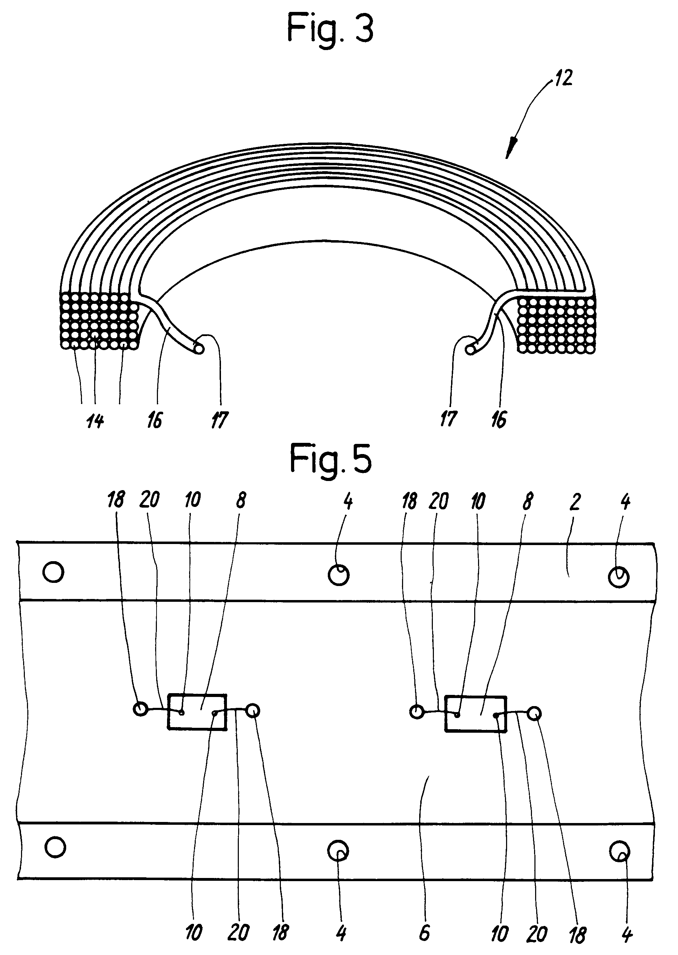

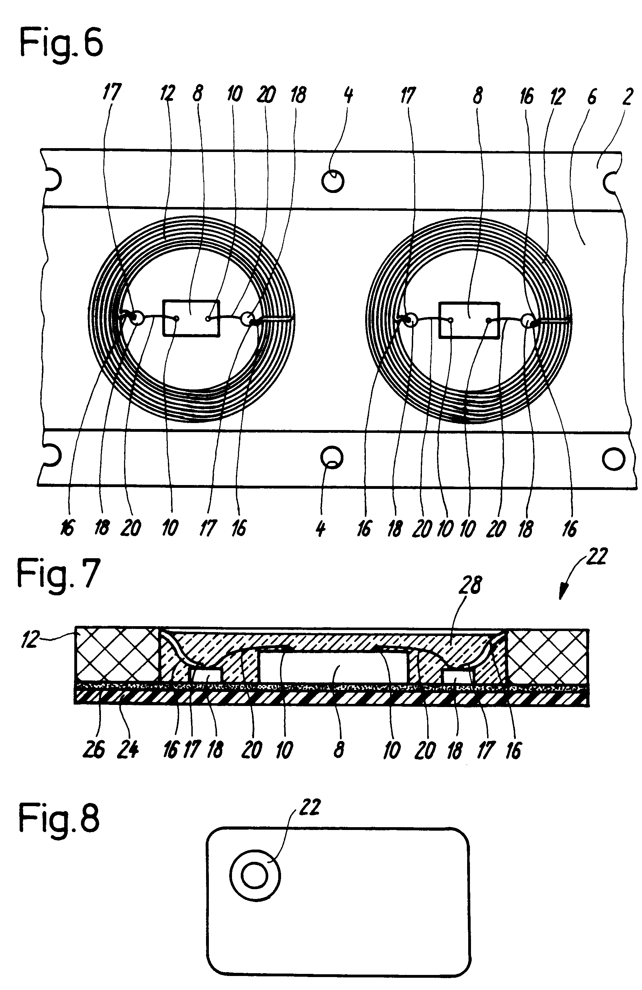

Cela dit, on se munit également au départ d'un certain nombre de puces 8 de forme sensiblement parallélépipédique, comme celle de la figure 2, qui ne présentent évidemment ici que deux bornes de connexion 10 du côté de leur face avant, d'un nombre égal de bobines 12, comme celle qui est représentée partiellement sur la figure 3, et d'un nombre deux fois plus grand de petits plots métalliques 18, de forme par exemple cylindrique et nettement moins volumineux que les puces, comme celui que l'on peut voir sur la figure 4.

Comme on peut s'en rendre compte les bobines 12 que l'on utilise dans le cas présent sont des bobines cylindriques plates et autoporteuses, constituées chacune par plusieurs couches de spires jointives et coaxiales 14, réalisées au moyen d'un fil métallique très fin.

Pour obtenir une bobine de ce genre on utilise un fil de préférence en cuivre, entouré d'une gaine de matière isolante et thermo-adhérente, on enroule ce fil autour d'un support cylindrique et on chauffe l'ensemble de manière à faire fondre partiellement la matière isolante pour que toutes les parties de la gaine qui entourent les spires de fil et qui sont en contact les unes avec les autres se soudent entre elles lorsqu'on laisse ensuite la bobine et le support se refroidir, avant de les séparer.

De plus, lorsqu'on fabrique cette bobine, on s'arrange pour que, premièrement, son diamètre extérieur soit le même que celui des modules que l'on veut produire, pour que, deuxièmement, sa hauteur soit égale à la différence entre la hauteur de ces modules et la somme des épaisseurs du ruban 2 et de la couche de matière adhésive 6 (voir figure 1) et pour que, troisièmement, les deux parties terminales 16 du fil de bobinage, que l'on prend soin de laisser libres pour assurer sa connexion, partent d'un même bord de sa surface intérieure et par exemple d'endroits à peu près diamétralement opposés, de façon à pouvoir être rabattus plus tard à l'intérieur de l'espace qu'elle entoure, comme le montre la figure 3.

Enfin, en ce qui concerne les plots métalliques 18, il suffit, pour en disposer, de les découper dans une plaque ou dans une bande du matériau dont on veut qu'ils soient constitués. Ce matériau est de préférence le nickel ou le maillechort qui est commercialisé sous la marque "ARCAP" et qui se compose d'environ 56 % de cuivre, 25 % de nickel, 17 % de zinc et 2 % de métaux additionnels.

Lorsque l'on est en possession de ces différents éléments de base les deux premières opérations que l'on effectue consistent à coller sur le ruban 2 d'abord des paires de plots 18 et ensuite les puces 8 de façon à ce qu'ils forment des groupes d'éléments identiques, régulièrement répartis dans le sens de la longueur du ruban et à ce que chaque plot d'une paire se trouve à proximité de l'une des bornes de connexion 10 de la puce à laquelle il est associé, comme le montre la figure 5.

D'après ce que l'on a dit précédemment à propos de la couche de matière adhésive 6 on comprend très facilement que lorsque l'on parle ici de coller les plots et les puces sur le ruban cela signifie tout simplement que l'on applique respectivement l'une de leurs faces et leur face arrière sur cette couche.

D'autre part, tels qu'ils sont représentés sur la figure 5 les plots 18 et les puces 8 sont tous situés sur la ligne médiane du ruban et chaque puce est placée longitudinalement entre les plots de chaque paire. Cette disposition convient bien pour des puces comme celles de la figure 2, qui ont une borne de connexion à chaque bout, et pour des bobines 12 dont les parties libres 16 partent effectivement de deux endroits diamétralement opposés du bord de leur surface interne mais ce n'est évidemment qu'une possibilité parmi d'autres. On pourrait aussi, par exemple, placer les puces et les plots de la même façon mais dans le sens de la largeur du ruban ou mettre les plots à côté des puces ou d'un côté et de l'autre de celles-ci. D'une façon générale l'agencement de ces plots et de ces puces doit être celui qui facilite le plus le montage des différentes parties des modules sur le ruban et la réalisation des liaisons électriques qu'ils comportent. Par contre, il est nécessaire qu'ils soient rassemblés dans la partie centrale de ce ruban.

Quelle que soit la solution que l'on adopte, ce que l'on fait après avoir collé les plots et les puces c'est de les relier électriquement. Pour cela on utilise la technique de la connexion par fils plus connue sous l'appellation anglaise de "Wire Bonding". Autrement dit, on soude l'un après l'autre deux fils fins 20, par exemple en aluminium, d'abord sur l'une des bornes de connexion des puces puis sur l'un des plots des paires.

Lorsque cette opération est terminée on colle les bobines 12 sur le ruban, par leur face arrière, c'est-à-dire celle qui se trouve du côté opposé à celui d'où partent les parties terminales 16, de façon à ce qu'elles entourent les différents ensembles de puces et de plots, comme on peut le voir sur la figure 6, et à ce que leurs bornes c'est-à-dire les extrémités 17 desdites parties terminales soient chacune en contact avec un plot ou au-dessus et à une faible distance de celui-ci.

Ensuite on soude les extrémités 17 des parties terminales 16 sur les plots. Pour cela il n'est pas nécessaire de dénuder ces extrémités car à ce moment-là la matière de la gaine qui entoure le fil de bobinage fond localement et n'empêche pas l'établissement d'un bon contact électrique entre ce fil et les plots. Il n'en serait pas de même si l'on fixait les extrémités des parties terminales sur les plots au moyen d'une colle conductrice, ce qui serait également possible.

Par ailleurs, pendant cette phase de soudage ou après, on doit veiller à ce que les parties terminales soient entièrement logées dans les espaces entourés par les bobines. En ce qui concerne les fils 20, ce problème ne se pose pas car même si ces modules doivent être très minces la hauteur des bobines est toujours au moins une fois et demi ou deux fois plus grande que l'épaisseur des puces.

Après en être arrivé à ce stade qui est illustré par la figure 6 et où tous les éléments de base 8, 12 et 18 des modules sont montés sur le ruban et reliés électriquement entre eux, on remplit entièrement les espaces entourés par les bobines d'une matière adhésive, isolante et thermodurcissable, qui est encore à l'état fluide et qui est de préférence opaque pour protéger les puces contre la lumière, au moins jusqu'à ce que les modules soient incorporés dans les cartes ou les autres objets auxquels ils sont destinés. Cette matière peut être la même que celle qui constitue la couche 6 que l'on a déposée initialement sur le ruban 2, surtout si elle est effectivement opaque, ou une autre matière dont la température de solidification est à peu près la même.

Lorsque cette opération de remplissage a été effectuée on chauffe le ruban 2 avec les modules qu'il porte et qui sont alors presque terminés pour que la matière de remplissage et celle de la couche 6 se polymérisent et se solidifient complétement et pour achever la fixation des puces 8, des bobines 12 et des plots 18 sur le ruban.

Ensuite, il ne reste plus qu'à découper ce dernier en suivant le contour des bobines pour obtenir une série de modules 22, comme celui que l'on peut voir en coupe sur la figure 7, avec son substrat 24, sa couche de matière adhésive 26, sa matière de remplissage 28, sa bobine 12 qui est représentée schématiquement et toutes ses autres parties qui sont désignées par les mêmes repères que sur les figures 2 à 6.

Cette dernière opération qui permet de séparer les modules 22 du ruban 2 peut être exécutée par celui qui les fabrique, s'il ne produit pas lui-même les objets qui les contiennent, auquel cas ces modules seront livrés en vrac, généralement après avoir été testés, ou par un client.

Si ces modules 22 sont destinés à des cartes très minces, comme par exemple des cartes de crédit standardisées, ils peuvent être ensuite collés dans des logements de même forme et de mêmes dimensions qu'eux, prévus dans des corps de cartes, comme le montre la figure 8 et exactement de la même façon que des modules à contacts.

Ces logements peuvent être des ouvertures si les modules ont la même épaisseur que les corps de cartes ou des cavités si les modules sont plus minces.

Dans les deux cas, les bobines assureront une très bonne protection des puces 8, des fils 20, de leurs jonctions avec les plots de connexion des puces et les plots 18 et de celles des bornes 17 de ces bobines avec ces derniers, contre toutes les contraintes auxquelles les cartes seront soumises par la suite.

De plus, on prendra soin de recouvrir des deux côtés les corps des cartes et les modules de films en matière plastique de protection, mais même sans cela ces modules ne risqueraient pas d'être détériorés par l'humidité, une atmosphère polluante ou d'autres facteurs qui peuvent empêcher le bon fonctionnement ou le fonctionnement tout court des cartes à contacts.

D'autre part, si les modules 22 sont prévus pour des clefs ou des étiquettes qui peuvent être beaucoup plus épaisses que les cartes dont on vient de parler, ils peuvent alors être noyés complétement dans une matière plastique.

Enfin, comme on l'a dit précédemment, ce premier mode de mise en oeuvre du procédé selon l'invention que l'on vient de décrire convient aussi pour des modules à plusieurs puces. En effet, si l'on veut réaliser, par exemple, des modules à deux puces il suffit pour cela de se munir au départ d'un certain nombre de chacune de ces puces et d'un nombre de plots métalliques égal à ce nombre de premières ou de secondes puces multiplié par le nombre de bornes de connexion que comportent les puces qui doivent être reliées aux bobines, par exemple les premières, de coller ces plots et ensuite les puces sur un ruban préparé comme le ruban 2, en les disposant correctement, et de relier par la technique du "Wire Bonding" les bornes de connexion des premières puces à tous les plots et celles des secondes puces aux plots qui ne sont pas réservés à la connexion des premières puces avec les bobines. Après cela, il n'y a plus qu'à effectuer exactement les mêmes opérations que pour des modules à une seule puce.

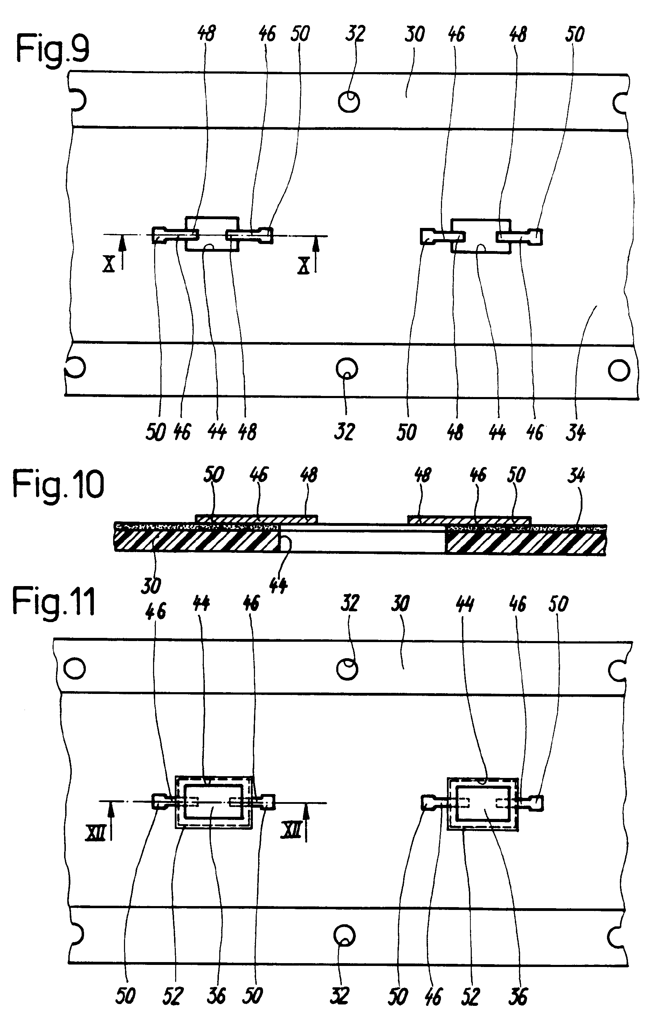

Pour fabriquer des modules conformément au second mode de mise en oeuvre du procédé selon l'invention que l'on a choisi comme exemple et qui est illustré par les figures 9 à 13, on se munit au début d'un ruban en matière isolante 30, par exemple en Mylar ou en Kapton, que l'on soumet aux mêmes opérations que dans le cas du premier mode de mise en oeuvre pour qu'il présente le long de ses bords des perforations 32 et pour que la partie centrale de l'une de ses faces soit recouverte d'une couche 34 de matière adhésive isolante qui peut être ici une matière thermodurcissable à l'état B ou une matière thermoplastique par exemple du type connu sous le nom de "Hot melt".

Une autre solution consisterait là aussi à se procurer un ruban standardisé déjà tout préparé.

Par ailleurs, on se munit également d'une série de puces 36 qui comportent chacune deux bornes de connexion 38 et d'une série de bobines 40 qui sont réalisées de la même façon que la bobine 12 de la figure 3 et qui présentent donc elles aussi des parties terminales de fils libres 22 mais qui n'ont pas nécessairement les mêmes dimensions. Par exemple, si l'on veut obtenir des modules de mêmes dimensions que celles des modules 22 avec des puces de même épaisseur, ces bobines 40 doivent avoir le même diamètre extérieur que les bobines 12 et elles peuvent avoir le même diamètre intérieur mais, pour une raison que l'on comprendra par la suite, leur hauteur peut être plus faible et cette différence de hauteur peut être compensée par une épaisseur du ruban 30 plus grande que celle du ruban 2.

Lorsque l'on dispose de ces différents éléments on utilise tout d'abord la technique généralement désignée par l'abréviation TAB de l'expression anglaise "Tape Automatic Bonding" pour à la fois fixer les puces sur le ruban et réaliser des conducteurs qui permettront de relier leurs bornes de connexion aux extrémités des parties terminales du fil des bobines.

Plus précisément, on commence par soumettre le ruban 30 avec sa couche de matière adhésive 32 à une opération d'étampage pour qu'il présente dans le sens de sa longueur et au milieu de sa largeur des ouvertures rectangulaires équidistantes 44, de longueur et de largeur légèrement supérieures à celles des puces, comme le montrent les figures 9 et 10.

A la suite de cela, on colle une feuille métallique sur le ruban 30 en l'appliquant à chaud sur la couche de matière adhésive 32 pour qu'elle adhère fortement à celle-ci, et on fait appel à la photolithographie pour éliminer la plus grande partie de cette feuille et ne laisser subsister, pour chaque ouverture 44, que deux petites bandes conductrices 46 qui ont chacune une extrémité libre 48 située au-dessus de cette ouverture et qui présentent de préférence à l'autre bout une partie élargie 50 pour former une plage de connexion pour l'une des bornes 43 d'une bobine (voir figures 9 et 10).

De plus, ces bandes conductrices 46 peuvent être avantageusement disposées comme sur le dessin, c'est-à-dire dans le sens de la longueur du ruban et de part et d'autre des ouvertures 44, mais ceci n'est pas une obligation.

Comme l'usinage photolithographique comporte une étape d'attaque chimique de la feuille métallique par un solvant qui produit une pollution ionique du ruban isolant et des bandes conductrices, on soumet ensuite l'ensemble à un nettoyage approprié pour faire disparaître toute trace de cette pollution.

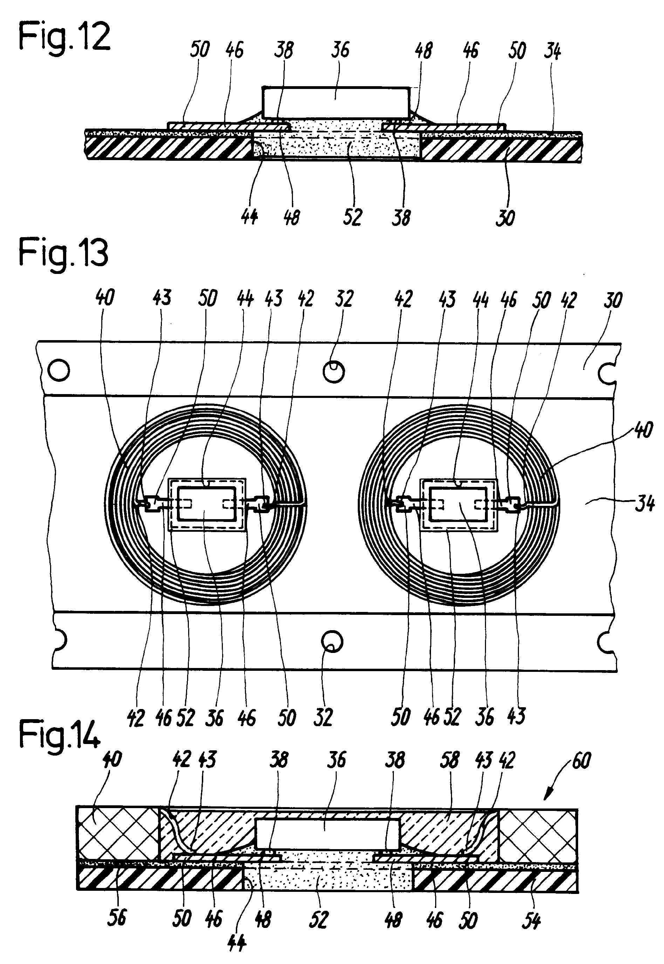

Après avoir effectué cette opération de nettoyage, on soude les bornes de connexion 38 d'une puce 36 aux extrémités libres 48 de chaque paire de bandes conductrices 46, comme le montrent les figures 11 et 12, c'est-à-dire de façon que la puce se trouve du même côté du ruban que ces bandes, ce qui est le contraire de ce que l'on fait généralement quand on utilise la technique du TAB.

Enfin, la dernière opération à laquelle on procède et qui fait encore partie de cette technique, c'est de combler les espaces situés entre les faces avant des puces 36 et la face avant du ruban 30 ainsi que les ouvertures 44 de celui-ci avec une matière adhésive, isolante, opaque et relativement dure 52, par exemple du silicone. Cette matière adhésive a non seulement pour rôle de protéger les circuits intégrés des puces contre la lumière, mais aussi d'empêcher dans une large mesure que les contraintes auxquelles les substrats des modules pourront être soumis, si ces modules sont destinés à des cartes minces, de se répercuter au niveau des soudures des bornes de connexion des puces sur les extrémités libres des bandes conductrices qui, comme on l'a déjà indiqué, soit des points très fragiles.

Lorsque cette opération est terminée on se trouve au même stade d'avancement que lorsque l'on a fini de souder les fils 20 sur les bornes de connexion des puces 8 et sur les plots métalliques 18 dans le cas du précédent mode de mise en oeuvre (voir figure 5).

Autrement dit, il reste encore à fixer les bobines 40 par leur face arrière sur le ruban, autour des puces 36 et des bandes conductrices 46 et à souder leurs bornes 43 sur les plages de connexion 50 de ces bandes, comme le montre la figure 13, à remplir l'espace entouré par chaque bobine d'une matière adhésive isolante, qui n'a pas besoin ici d'être opaque, à tester électriquement les modules et à les séparer du ruban en découpant celui-ci autour des bobines.

Pour fixer les bobines et combler les espaces qu'elles entourent on peut choisir ici parmi les matières adhésives thermodurcissables, les matières adhésives thermoplastiques et les matières adhésives qui se polymérisent et durcissent à froid, celles qui conviennent le mieux et sans que la matière de remplissage soit forcément la même que celle qui sert au collage des bobines. Toutefois, si l'on décide d'employer au moins une matière thermoplastique et si la couche 34 dont on a recouvert au début le ruban 30 est constituée par une matière de ce genre, on doit en prendre une qui fond à une température plus basse que celle de cette couche 34.

La figure 14 est une vue analogue à celle de la figure 7, qui montre l'un des modules 60 que l'on obtient lorsque l'on fait appel à ce deuxième mode de mise en oeuvre que l'on vient de décrire. Le substrat de ce module, ce qui subsiste de la couche de matière isolante 34 et la matière adhésive de remplissage de l'espace entouré par la bobine sont désignés ici respectivement par les repères 54, 56 et 58.

Si l'on veut obtenir des modules du même genre mais avec deux puces, il suffit:
1. de percer dans le ruban et pour chaque module deux ouvertures proches l'une de l'autre et de dimensions adaptées à celles des puces;
2. de former sur le ruban, en même temps que les bandes conductrices qui permettront de connecter deux des bornes de l'une des puces à une bobine, des bandes conductrices supplémentaires qui ont chacune une extrémité libre située au-dessus de chaque ouverture, en tenant compte de la position des bornes de connexion des puces qui doivent être reliées ensemble;
3. de souder les bornes de connexion de chaque puce aux extrémités libres des bandes conductrices qui leur sont destinées; et
4. de combler les espaces vides entre les faces avant des puces et le ruban en même temps que les ouvertures de celui-ci d'une matière adhésive isolante et opaque.

Après cela, on procède de la même façon que dans le cas de modules à une seule puce.

Si l'on compare maintenant les figures 7 et 14 on peut comprendre pourquoi, pour des modules 22 et 60 de mêmes dimensions, les bobines 12 peuvent être plus épaisses que les bobines 40 et les substrats 24 plus minces que les substrats 54 et pourquoi il vaut même beaucoup mieux qu'il en soit ainsi. La première raison c'est que, à cause des fils 20, les puces 8 et ces fils occupent en général une place en hauteur plus importante que les puces 36 et les bandes conductrices 46. La deuxième raison qui n'est pas totalement indépendante de la première c'est que, dans le cas des modules 22, les faces avant des puces qui sont sensibles à la lumière et les parties mécaniquement fragiles que sont les fils 20 et leurs soudures sur les bornes de connexion des puces se trouvent plutôt du côté des faces avant de ces modules et de leurs bobines 12. Il y a donc intérêt à ce que la couche de matière adhésive 28 qu'il y a au-dessus des puces et des fils soit épaisse. De plus, comme les autres parties fragiles que sont les soudures des fils 20 et des bornes 17 des bobines sur les plots métalliques 18 sont bien protégées par ceux-ci, il n'y a pas d'inconvénient à ce que l'épaisseur des substrats 24 soit relativement faible. Par contre, dans les modules 60 les faces avant des puces 36 et les parties mécaniquement fragiles, c'est-à-dire les extrémités 48 des bandes conductrices 46 et les soudures des bornes de connexion des puces 36 et des bornes 43 des bobines 40 sur ces bandes, sont situées du côté des substrats 54. Par conséquent, il vaut mieux que ces substrats soient assez épais, pour être plus rigides et se déformer moins facilement que les substrats 24, et qu'il en soit de même pour les couches de matière adhésive 52.

Cela dit, il est bien clair que l'invention n'est pas limitée à des modules comme ceux des figures 7 et 14, à une ou plusieurs puces, ni aux façons de les fabriquer que l'on a décrites.

Par exemple, en utilisant des puces dont les bornes de connexion sont recouvertes d'une couche d'or et des bobines en fil de cuivre très fin, comme celle de la figure 3, il serait possible de coller ces deux éléments par leurs faces arrière sur le ruban et de souder directement les bornes des bobines sur les bornes de connexion des puces. Les liaisons électriques entre les bobines et les puces seraient alors réduites à ces soudures.

D'autre part, on pourrait aussi, dans certains cas, se dispenser de recouvrir initialement le ruban perforé d'une couche de matière adhésive et coller les puces, les bobines et éventuellement des éléments d'interconnexion comme les plots 18 directement sur celui-ci.

Enfin, il est utile de préciser que le mot "bobine" doit être interprété ici dans un sens large. Il ne s'agit pas seulement de l'élément conducteur qui forme une inductance constituée d'une ou plusieurs spires. Il peut y avoir en plus d'autres éléments. Par exemple, plutôt que de faire appel à des bobines autoporteuses comme celle de la figure 3 pour réaliser des modules selon l'invention, on pourrait utiliser des bobines qui seraient constituées par un support isolant creux, en matière plastique et un fil métallique fin et gainé, enroulé autour de celui-ci, ou bien encore des bobines qui comprendraient une ou plusieurs spires de fil ou de ruban conducteur noyées dans un bloc de matière plastique de forme annulaire, à l'intérieur duquel émergeraient les parties terminales de ce fil ou de ce ruban. A ce propos il faut noter également que lorsque l'on parle d'une bobine annulaire, cela ne signifie pas qu'elle est forcément circulaire. Elle peut être aussi carrée, rectangulaire ou autre.

## Revendications

1. Module électronique pour un objet portatif de petite dimension tel qu'une carte ou une clef, à circuit intégré, comprenant un substrat en matière électriquement isolante (24; 54), une puce de circuit intégré (8; 36) de forme sensiblement parallélépipédique, qui présente une face avant munie d'au moins deux bornes de connexion (10; 38) et une face arrière et qui est fixée au moins indirectement sur ledit substrat, une bobine (12; 40) munie de deux bornes (17; 43) et également fixée sur ledit substrat, pour permettre un couplage inductif entre le module (22; 60) et un appareil avec lequel ledit objet sera amené à coopérer, et des liaisons électriques respectives (18, 20; 46) entre les bornes de connexion de la puce et les bornes de la bobine, ladite bobine ayant une forme annulaire et entourant un espace dans lequel sont logées ladite puce et lesdites liaisons électriques, caractérisé par le fait que ladite bobine a une hauteur supérieure à l'épaisseur de ladite puce et par le fait que ledit espace est rempli d'une matière adhésive (28; 58), électriquement isolante et durcie de telle sorte que la bobine forme une structure de protection de ladite puce.

2. Module électronique selon la revendication 1, caractérisé par le fait que ladite bobine (12; 40) comprend un élément conducteur qui forme au moins une spire (14) autour dudit espace et qui présente deux parties terminales (16; 42) situées à l'intérieur de celui-ci et dont les extrémités (17; 43) constituent lesdites bornes de la bobine.

3. Module électronique selon la revendication 2, caractérisé par le fait que ladite bobine est une bobine autoporteuse (12; 40) qui comprend plusieurs couches de spires jointives et sensiblement coaxiales (14), qui sont formées par un fil métallique fin, entouré d'une gaine en matière électriquement isolante, et qui sont liées entre elles.

4. Module électronique selon la revendication 2 ou 3, caractérisé par le fait que la puce (8) est fixée sur le substrat (24) par sa face arrière et que lesdites liaisons électriques comprennent deux plots métalliques (18) qui sont également fixés sur ledit substrat et sur chacun desquels est soudée l'une des bornes (17) de la bobine (12), et deux fils métalliques fins (20) qui sont soudés chacun à une extrémité sur l'une des bornes de connexion (10) de la puce et à l'autre extrémité sur l'un desdits plots métalliques.

5. Module électronique selon la revendication 4, caractérisé par le fait que la puce (8), la bobine (12) et les plots métalliques (18) sont fixés sur ledit substrat (24) par l'intermédiaire d'une couche (26) de matière adhésive thermodurcissable et que la matière adhésive (28) qui remplit l'espace entouré par la bobine est une matière également thermodurcissable et opaque.

6. Module électronique selon la revendication 2 ou 3, caractérisé par le fait que la puce (36) est disposée de façon que sa face avant se trouve du côté dudit substrat (54) et que lesdites liaisons électriques comprennent deux bandes conductrices (46) qui sont également fixées sur ledit substrat et qui ont chacune deux extrémités (50, 48) sur lesquelles sont soudées respectivement l'une des bornes (43) de la bobine (40) et l'une des bornes de connexion (38) de la puce.

7. Module électronique selon la revendication 6, caractérisé par le fait que la bobine (40) et les bandes conductrices (46) sont fixées sur ledit substrat (54) par l'intermédiaire d'une couche (56) de matière adhésive thermodurcissable ou thermoplastique.

8. Module électronique selon la revendication 7, caractérisé par le fait que l'ensemble formé par le substrat (54) et la couche (56) de matière adhésive présente une ouverture rectangulaire (44), de longueur et de largeur légèrement supérieures à celles de la puce (36), au-dessus de laquelle se trouvent cette puce et les extrémités (48) des bandes conductrices (46) sur lesquelles ses bornes de connexion sont soudées, et par le fait que cette ouverture et l'espace situé entre la face avant de la puce et ledit ensemble sont comblés par une matière adhésive isolante, opaque et durcie (52).

9. Module électronique selon l'une quelconque des revendications précédentes, caractérisé par le fait que la bobine (12; 40) est cylindrique, que le substrat (24; 54) est rond et que le diamètre de ce substrat est sensiblement égal au diamètre extérieur de la bobine.

10. Procédé de production en série de modules électroniques tels que définis dans l'une quelconque des revendications précédentes, caractérisé par les étapes suivantes :
- on se munit
- d'un ruban (2; 30) en matière électriquement isolante,
- on fixe au moins indirectement les puces sur le ruban, dans sa partie centrale et de façon à ce qu'elles soient régulièrement réparties dans le sens de sa longueur;
- on fixe les bobines sur le ruban, autour des puces;
- on réalise lesdites liaisons électriques entre les bornes de connexion des puces et les bornes des bobines;
- on remplit les espaces entourés par les bobines d'une matière adhésive isolante et durcissable (28; 58); et, après que cette matière ait durci,
- on découpe le ruban autour de chaque bobine pour obtenir les modules.

11. Procédé selon la revendication 10, caractérisé par le fait que l'on fixe les puces (8) sur le ruban (2) par leurs faces arrière et que, pour réaliser les liaisons électriques entre la puce et la bobine (12) de chaque module, on fixe également sur le ruban deux plots métalliques (18), de façon à ce qu'ils se trouvent entre cette puce et cette bobine, on relie les bornes de connexion (10) de la puce aux plots par deux fils métalliques fins (20) en soudant l'une des extrémités de chacun de ces fils sur l'une des bornes de connexion de la puce et son autre extrémité sur l'un des plots et on soude une borne (17) de la bobine sur chaque plot.

12. Procédé selon la revendication 11, caractérisé par le fait que, pour fixer les puces (8), les plots métalliques (18) et les bobines (12) sur le ruban (2), on dépose initialement sur l'une des faces de celui-ci une couche (6) de matière adhésive isolante et thermodurcissable, à l'état B, on colle ces puces, ces plots et ces bobines sur cette couche de matière adhésive et, après que les espaces entourés par les bobines aient été remplis d'une matière adhésive (28), on chauffe le tout pour que la matière adhésive de ladite couche se polymérise et se durcisse complètement.

13. Procédé selon la revendication 12, caractérisé par le fait que la matière adhésive (28) dont on remplit les espaces entourés par les bobines (12) est également une matière thermodurcissable qui se polymérise et se durcit en même temps que la matière de ladite couche (6).

14. Procédé selon la revendication 10, caractérisé par le fait que pour fixer la puce (36) de chaque module sur le ruban (30) et réaliser les liaisons électriques entre ses bornes de connexion (38) et la bobine (40) de ce module, on forme tout d'abord sur le ruban deux bandes conductrices (46), on soude les bornes de connexion de la puce chacune à l'une des extrémités (48) d'une bande et, après que la bobine ait été fixée sur le ruban, on soude ses bornes (43) aux autres extrémités (50) de ces bandes.

15. Procédé selon la revendication 14, caractérisé par le fait que, pour former lesdites bandes conductrices (46), on dépose initialement sur l'une des faces du ruban (30) une couche (34) de matière adhésive isolante et thermodurcissable ou thermoplastique, on colle une feuille métallique sur le ruban en l'appliquant à chaud sur cette couche de matière adhésive et on utilise la technique de la photolithographie pour éliminer la plus grande partie de la feuille métallique et ne laisser subsister que les bandes conductrices.

16. Procédé selon la revendication 15, caractérisé par le fait que, pour pouvoir souder les bornes de connexion (38) des puces (36) aux extrémités (48) des bandes conductrices (46), on découpe dans le ruban (30), après avoir déposer sur lui ladite couche (34) de matière adhésive, des ouvertures rectangulaires (44) de longueur et de largeur légèrement supérieures à celles des puces, aux endroits où ces puces devront se trouver et de façon que les extrémités (48) des bandes conductrices auxquelles leurs bornes de connexion seront ensuite soudées soient situées au-dessus de ces ouvertures; et par le fait qu'après avoir formé les bandes conductrices sur le ruban et soudé les bornes de connexion des puces sur ces bandes on comble lesdites ouvertures et les espaces situés entre les faces avant des puces et l'ensemble formé par le ruban et sa couche de matière adhésive d'une matière adhésive isolante, opaque et durcissable (52).

17. Procédé selon l'une quelconque des revendications 10 à 16, caractérisé par le fait que les bobines (12; 40) que l'on utilise sont des bobines cylindriques et qu'à la fin on découpe le ruban (2; 30) en suivant leur contour pour obtenir des modules (22, 60) également cylindriques et de diamètre égal au diamètre extérieur de ces bobines.

## Patentansprüche

1. Elektronikmodul für einen tragbaren Gegenstand kleiner Abmessungen, wie eine Karte oder einen Schlüssel, mit integriertem Schaltkreis, umfassend ein Substrat aus elektrisch isolierendem Material (24, 54), einen integrierten Schaltkreis-Chip (8, 36) in im wesentlichen parallelepipedischer Form, der eine mit mindestens zwei Anschlußklemmen (10, 38) versehene Vorderseite und eine Rückseite aufweist und mindestens indirekt auf dem Substrat befestigt ist, mit einer Spule (12, 40), versehen mit zwei Klemmen (17, 43) und ebenfalls auf dem Substrat befestigt zum Ermöglichen einer induktiven Kopplung zwischen dem Modul (22, 60) und einem Apparat, mit dem der Gegenstand in Wirkverbindung zu bringen ist, und mit jeweiligen elektrischen Verbindungen (18, 20, 46) zwischen den Anschlußklemmen des Chips und den Klemmen der Spule, welche Spule eine Ringform aufweist und einen Raum umschließt, in dem der Chip und die elektrischen Anschlüsse untergebracht sind, dadurch gekennzeichnet, daß die Spule eine Höhe aufweist, die größer ist als die Dicke des Chips und daß der Raum mit einem adhäsiven Material (28, 58) gefüllt ist, das elektrisch isolierend und ausgehärtet ist derart, daß die Spule eine Schutzstruktur des Chips bildet.

2. Elektronikmodul nach Anspruch 1, dadurch gekennzeichnet, daß die Spule (12, 40) ein leitendes Element umfaßt, das mindestens eine Windung (14) um den Raum bildet und zwei Endpartien (16, 42) aufweist, die sich im Inneren desselben befinden und deren Enden (17, 43) die Klemmen der Spule bilden.

3. Elektronikmodul nach Anspruch 2, dadurch gekennzeichnet, daß die Spule eine selbsttragende Spule (12, 40) ist, die mehrere Lagen von aneinanderstoßenden und im wesentlichen koaxialen Windungen (14) umfaßt, die von einem feinen Metalldraht gebildet werden, umschlossen von einer Hülle aus elektrisch isolierendem Material, und welche Windungen miteinander verbunden sind.

4. Elektronikmodul nach Anpruch 2 oder 3, dadurch gekennzeichnet, daß der Chip (8) auf dem Substat (24) mit seiner Rückseite befestigt ist, und daß die elektrischen Anschlüsse zwei metallische Kissen (18) umfassen, die ebenfalls an dem Substrat befestigt sind und an jeden von ihnen eine der Klemmen (17) der Spule (12) angelötet ist, sowie zwei feine metallische Drähte (20), die jeweils mit einem Ende an eine der Anschlußklemmen (10) des Chips und mit dem anderen Ende an die metallischen Kissen angelötet sind.

5. Elektronikmodul nach Anspruch 4, dadurch gekennzeichnet, daß der Chip (8), die Spule (12) und die metallischen Kissen (18) auf dem Substrat (24) mittels einer Schicht (26) aus thermoaushärtbarem adhäsivem Material befestigt sind und daß das adhäsive Material (28), welches den von der Spule umschlossenen Raum füllt, ein ebenfalls thermohärtbares und opakes Material ist.

6. Elektronikmodul nach Anspruch 2 oder 3, dadurch gekennzeichnet, daß der Chip (36) derart angeordnet ist, daß seine Vorderseite sich an der Seite des Substrats (54) befindet, und daß die elektrischen Anschlüsse zwei leitende Bänder (46) umfassen, die ebenfalls an dem Substrat befestigt sind und jeweils zwei Enden (50, 48) aufweisen, an die eine der Klemmen (43) der Spule (40) bzw. eine der Anschlußklemmen (38) des Chips angelötet sind.

7. Elektronikmodul nach Anspruch 6, dadurch gekennzeichnet, daß die Spule (40) und die leitenden Bänder (46) an dem Substrat (54) mittels einer Schicht (56) aus thermohärtbarem oder thermoplastischem adhäsiven Material befestigt sind.

8. Elektronikmodul nach Anspruch 7, dadurch gekennzeichnet, daß die Baugruppe, gebildet von dem Substrat (54) und der Schicht (56) aus adhäsivem Material eine rechteckige Öffnung (44) aufweist mit einer Länge und Breite, die etwas größer sind als jene des Chips (36), oberhalb welchem sich dieser Chip und die Enden (48) der leitenden Bänder (46), an die seine Anschlußklemmen angelötet sind, befinden, und daß diese Öffnung und der Raum zwischen der Vorderseite des Chips und der Baugruppe mit einem isolierenden opaken und aushärtbaren adhäsiven Material (52) aufgefüllt ist.

9. Elektronikmodul nach einem der vorangehenden Ansprüche, dadurch gekennzeichnet, daß die Spule (12; 40) zylindrisch ist, daß das Substrat (24, 54) rund ist und daß der Durchmesser dieses Substrats im wesentlichen gleich dem Außendurchmesser der Spule ist.

10. Verfahren für die Serienherstellung von Elektronikmodulen nach einem der vorangehenden Ansprüche, gekennzeichnet durch die folgenden Schritte:
- man stellt einen Streifen (2, 30) aus elektrisch isolierendem Material bereit,
- man befestigt mindestens indirekt die Chips auf dem Streifen in seiner zentralen Partie und derart, daß sie gleichförmig in Richtung von dessen Länge verteilt sind,
- man befestigt die Spulen auf dem Streifen rings um die Chips,
- man realisiert die elektrischen Anschlüsse zwischen den Anschlußklemmen des Chips und den Klemmen der Spule,
- man füllt den von den Spulen umschlossenen Raum mit einem isolierenden und aushärtbaren adhäsiven Material (28, 58), und nach dessen Aushärtung
- schneidet man den Streifen rings um jede Spule zum Erhalten der Module.

11. Verfahren nach Anspruch 10, dadurch gekennzeichnet, daß man die Chips (8) auf dem Streifen (2) mit ihren Rückseiten befestigt und daß für das Realisieren der elektrischen Anschlüsse zwischen dem Chip und der Spule (12) jedes Moduls man außerdem auf dem Streifen zwei metallische Kissen (18) befestigt, derart, daß sie sich zwischen diesem Chip und dieser Spule befinden, daß man die Anschlußklemmen (10) des Chips mit den Kissen über zwei feine metallische Drähte (20) verbindet unter Anlöten eines Endes jedes dieser Drähte an eine der Anschlußklemmen des Chips und des anderen Endes an eines der Kissen, und daß man eine Klemme (17) der Spule an jeweils ein Kissen anlötet.

12. Verfahren nach Anspruch 11, dadurch gekennzeichnet, daß zum Befestigen der Chips (8), der metallischen Kissen (18) und der Spulen (12) auf dem Streifen (2) man zunächst auf einer der Seiten desselben eine Schicht (6) aus isolierendem und thermohärtbaren adhäsiven Material im Zustand B aufbringt, daß man diese Chips, diese Kissen und diese Spulen auf diese adhäsive Schicht aufklebt und, nachdem die von den Spulen umschlossenen Räume mit einem adhäsiven Material (28) gefüllt worden sind, man das Ganze erhitzt, damit das adhäsive Material der genannten Schicht polymerisiert und vollständig aushärtet.

13. Verfahren nach Anspruch 12, dadurch gekennzeichnet, daß das adhäsive Material (28), mit dem die von den Spulen (12) umschlossenen Räume gefüllt sind, ebenfalls ein thermohärtbares Material ist, das polymerisiert und aushärtet gleichzeitig mit dem Material der Schicht (6).

14. Verfahren nach Anspruch 10, dadurch gekennzeichnet, daß zum Befestigen des Chips (36) jedes Moduls auf dem Streifen (30) und Herstellen der elektrischen Verbindungen zwischen seinen Anschlußklemmen (38) und der Spule (40) dieses Moduls man zunächst auf dem Streifen zwei leitende Bänder (46) ausbildet, man die Anschlußklemmen des Chips jeweils an eines der Enden (48) eines Bandes anlötet und, nach Befestigung der Spule auf dem Streifen, ihre Klemmen (43) mit den anderen Enden (50) dieser Bänder verlötet werden.

15. Verfahren nach Anspruch 14, dadurch gekennzeichnet, daß zum Bilden der leitenden Bänder (46) man anfänglich auf einer der Seiten des Streifens (30) eine Schicht (34) aus isolierendem und thermohärtbarem oder thermoplastischem adhäsiven Material aufbringt, daß man eine metallische Folie auf den Streifen klebt unter Anwendung von Wärme auf diese Schicht aus adhäsivem Material und man die Technik der Photolithographie verwendet zum Eliminieren des größten Teils der metallischen Folie unter Belassung nur der leitenden Bänder.

16. Verfahren nach Anspruch 15, dadurch gekennzeichnet, daß, um die Anschlußklemmen (38) des Chips (36) an die Enden (48) der leitenden Bänder (46) anlöten zu können, man in den Streifen (30) nach Aufbringen der Schicht (34) aus adhäsivem Material rechteckige Öffnungen (44) mit einer Länge und Breite schneidet, die etwas größer sind als jene des Chips an den Stellen, wo die Chips sich befinden sollen, und derart, daß die Enden (48) der leitenden Bänder, an die die Anschlußklemmen danach angelötet werden, sich oberhalb dieser Öffnungen befinden, und daß nach Ausbildung der leitenden Bänder auf dem Streifen und Anlöten der Anschlußklemmen der Chips an diese Bänder man in die Öffnungen und die Räume, die sich zwischen der Vorderseite der Chips und der Baugruppe befinden, gebildet von dem Streifen und seiner Schicht aus adhäsivem Material, ein isolierendes opakes und härtbares adhäsives Material (52) einfüllt.

17. Verfahren nach einem der Ansprüche 10 bis 16, dadurch gekennzeichnet, daß die Spulen (12, 40), die man verwendet, zylindrische Spulen sind, und daß man am Schluß den Streifen (2; 30) wegschneidet, indem man ihrer Kontur folgt, um Module (22, 60) zu erhalten, die ebenfalls zylindrisch sind und einen Durchmesser besitzen gleich dem Außendurchmesser dieser Spule.

## Claims

1. Electronic module for a small portable object such as a card or a key having an integrated circuit, comprising a substrate of electrically insulating material (24; 54) a substantially parallelepipedic integrated circuit chip (8; 36) having a front surface provided with at least two connector lugs (10; 38) and a back surface and which is at least indirectly fixed to said substrate, a coil (12; 40) having two terminals (17; 43) and also fixed on said substrate for enabling inductive coupling of the module (22; 60) and an apparatus with which said object can cooperate, and respective electrical connections (18, 20; 46) between the chip's connector lugs and the coil's terminals, said coil having an annular form and surrounding a space in which said chip and said electrical connections are housed, characterized by the fact that said coil has a height higher than the thickness of said chip and by the fact that said space is filled with an hardened, electrically insulating adhesive material (28; 58) so that the coil forms a protective structure of said chip.

2. Electronic module according to claim 1, characterized by the fact that said coil (12; 40) comprises a conductive element forming at least one winding (14) around said space and having two terminal parts (16; 42) situated inside said space, which ends (17; 43) form said terminals of the coil.

3. Electronic module according to claim 2, characterized by the fact that said coil is a self-supporting coil (12; 40) comprising several layers of contiguous and substantially coaxial windings (14) formed of a fine metal wire sheathed in electrically insulating material and connected together.

4. Electronic module according to claim 2 or 3, characterized by the fact that the chip (8) is fixed on the substrate (24) by its back surface and that said electric connections comprise two metal studs (18) that are also fixed on said substrate and to each of which is soldered one of the terminals (17) of the coil (12), and two fine metal wires (20) each soldered at one end to one of the connector lugs (10) of the chip and at the other end to one of said metal studs.

5. Electronic module according to claim 4, characterized by the fact that the chip (8), the coil (12) and the metal studs (18) are fixed on said substrate (24) by means of a layer (26) of thermosettable adhesive material and that the adhesive material (28) filling the space surrounded by the coil is an opaque and also thermosettable material.

6. Electronic module according to claim 2 or 3, characterized by the fact that the chip (36) is arranged in such a manner that its front surface is located on the side of said substrate (54) and that said electric connections comprise two conductor strips (46) that are also fixed on said substrate and that each have two ends (50, 48) to which are respectively soldered one of the terminals (43) of the coil (40) and one of the connector lugs (38) of the chip.

7. Electronic module according to claim 6, characterized by the fact that the coil (40) and the conductor strips (46) are fixed on said substrate (54) by means of a layer (56) of thermosettable or thermoplastic adhesive material.

8. Electronic module according to claim 7, characterized by the fact that the assembly formed by the substrate (54) and the layer (56) of adhesive material has a rectangular opening (44), of length and width slightly greater than those of the chip (36), above which are located said chip and the ends (48) of the conductor strips (46) to which the connector lugs are soldered, and by the fact that this opening and the space situated between the front surface of the chip and said assembly are filled with an opaque, hardened insulating adhesive material (52).

9. Electronic module according to any one of the preceding claims, characterized by the fact that the coil (12; 40) is cylindrical, that the substrate (24; 54) is round and that the diameter of this substrate is substantially equal to the external diameter of the coil.

10. Method of mass producing electronic modules such as defined in any one of the preceding claims, characterized by the following steps :
- providing a tape (2; 30) of electrically insulating material;
- at least indirectly fixing the chips to the central part of the tape in such a manner that they are regularly spaced apart longitudinally of the tape;
- fixing the coils to the tape around the chips;
- providing said electrical connections between the chips' connector lugs and the coils' terminals;
- filling the spaces surrounded by the coils with a hardenable, insulating adhesive material (28; 58); and, after this material has hardened,
- cutting the tape around each coil to obtain the modules.

11. Method according to claim 10, characterized by the fact that chips (8) are fixed on the tape (2) by their back surfaces and that to make the electrical connections between the chip and the coil (12) of each module two metal studs (18) are also fixed onto the tape, between said chip and said coil, the connector lugs (10) of the chip are connected to the studs by two fine metals wires (20) by soldering one of the ends of each of these wires to one connector lug of the chip and its other end to one of the studs, and one terminal (17) of the coil is soldered to each stud.

12. Method according to claim 11, characterized by the fact that, to fix the chips (8), the metal studs (18) and the coils (12) to the tape (2), a layer (6) of insulating adhesive thermosettable material in the B state is deposited on one of the faces of the tape, said chips, studs and coils are stuck to this layer of adhesive material and, after the spaces surrounded by the coils have been filled with an adhesive material (28), the assembly is heated so that the adhesive material of said layer is fully polymerized and hardened.

13. Method according to claim 12, characterized by the fact that the adhesive material (28) filling the spaces surrounded by the coils (12) is also a thermosettable material which polymerizes and hardens at the same time as the material of said layer (6).

14. Method according to claim 10, characterized by the fact that to fix the chip (36) of each module to the tape (30) and to make the electrical connections between the connector lugs (38) of the chip and the coil (40) of this module, two conductor strips (46) are firstly formed on the tape, the connector lugs of the chip are soldered each to one of the ends (48) of a strip and, after the coil has been fixed to the tape, its terminals (43) are soldered to the other ends (50) of these strips.

15. Method according to claim 14, characterized by the fact that to form said conductor strips (46), a layer (34) of thermosettable or thermoplastic insulating adhesive material is deposited on one of the faces of the tape (30), a metal foil is stuck on the tape by hot pressing it on this layer of adhesive material and the major part of the metal foil is removed by photolithographs for only leaving the conductive strips.

16. Method according to claim 15, characterized by the fact that to solder the connector lugs (38) of the chips (36) to the ends (48) of the conductor strips (46), rectangular openings (44) having a length and width slightly greater than those of the chips are cut in the tape (30), after having deposited thereon said layer (34) of adhesive material, at locations where the chips are to be sited and in such a manner that the ends (48) of the conductor strips to which the connector lugs are to be soldered are situated above these openings; and by the fact that after having formed the conductor strips on the tape and soldered the chips' connector lugs to the tapes, said openings and the spaces situated between the front surfaces of the chips and the assembly formed by the tape and its layer of adhesive material are filled with a hardenable opaque insulating adhesive material (52).

17. Method according to any one of claims 10 to 16, characterized by the fact that the coils (12; 40) employed are cylindrical coils and as a final step the tape (2; 30) is cut around the peripheries of the coils to produce cylindrical modules (22; 60) of diameter equal to the outer diameter of said coils.
